# EUROPEAN PATENT APPLICATION

(11) **EP 1 820 777 A1**
(43) Date of publication of application: **22.08.2007**
(21) Application number: 05811545.2
(22) Date of filing: 30.11.2005
(51) Int. Cl.: C01B 33/02

(54) **PROCESS FOR PRODUCING POLYCRYSTALLINE SILICON INGOT**

(30) Priority: 30.11.2004 JP 2004347083
(71) Applicant: Noritake TCF CO., Ltd, Kariya-shi, Aichi 448-0813 (JP); Space Energy Corporation, Taito-ku Tokyo 1100005 (JP)
(72) Inventor: SAKAI, Yuichi, c/o SPACE ENERGY CORPORATION, Tokyo 1100005 (JP); KIMURA, Yoshimichi, c/o NORITAKE TCF CO., LTD., Togane-shi, Chiba 2830044 (JP)
(74) Representative: Grünecker, Kinkeldey, Stockmair & Schwanhäusser Anwaltssozietät
(86) International application number: PCT/JP2005/021969
(87) International publication number: WO 2006/059632

(57) **Abstract**

Provided is a process in which a polycrystalline silicon ingot improved in life time characteristics, which are correlated with the conversion efficiency of solar wafers, is inexpensively produced by the ordinary-pressure hydrogen-atmosphere melting method. In the process, the generation of oxygen and impurities in the silicon melt is inhibited and light-element impurities are removed through reaction or crystallization. Fine crystal grains can be grown at a high rate, and a high-purity polycrystalline silicon ingot having a crystal structure reduced in crystal defect can be grown.

A silicon raw material is melted in an atmosphere of 100% hydrogen at ordinary pressure or an elevated pressure to prepare a silicon melt and simultaneously dissolve hydrogen in the silicon melt. The silicon melt containing hydrogen dissolved therein is solidified. Thereafter, the solid is held at a high temperature around the solidification temperature to grow silicon crystal grains in the solid phase and thereby obtain a polycrystalline silicon ingot.

## Description

### Technical Field

The present invention relates to a process for producing a polycrystalline silicon ingot to be used for a solar cell or the like.

### Background Art

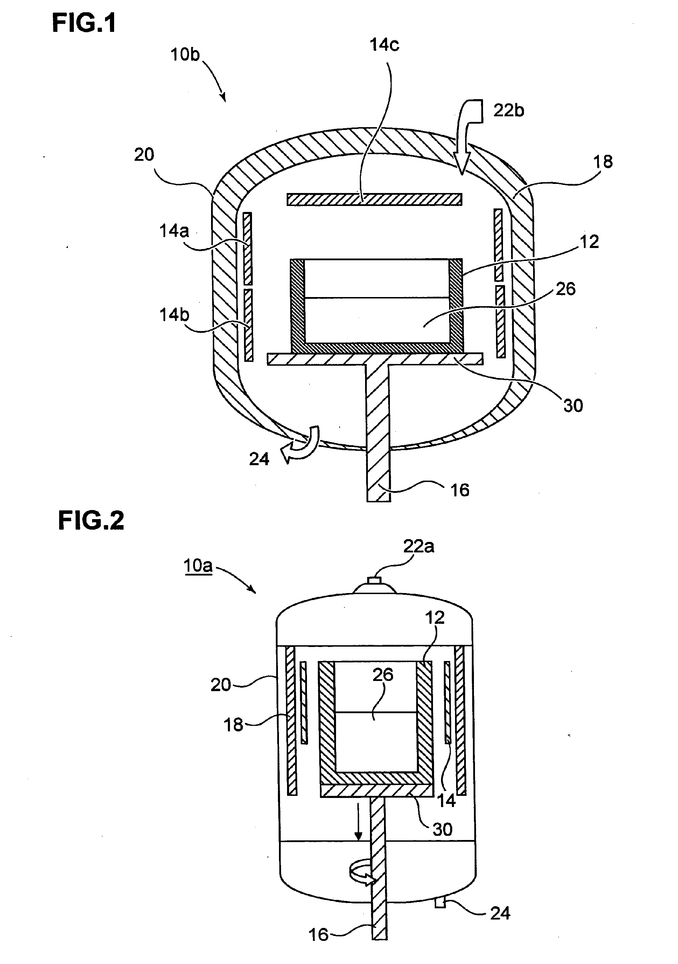

As a conventional process for producing a polycrystalline silicon ingot for a solar cell, a method of melting and solidifying a silicon raw material in an argon atmosphere under reduced pressure similar to a single crystal pulling method is generally known. Fig. 2 describes a melting furnace to be used in the conventional method. Fig. 2 is a schematic diagram showing an example of a conventional melting furnace. In Fig. 2, reference symbol 10a represents a melting furnace. The melting furnace 10a includes: a sagger 12; heating means 14 for heating the sagger 12; support means 16 for placing and raising or lowering the sagger 12 by rotating; a heat insulation material 18; and a chamber 20: The heat insulation material 18 is provided on inner surfaces of side walls of the chamber 20. An atmospheric gas such as an argon gas is introduced from a gas introduction port 22a and discharged from a discharge port 24. An operation of this structure will be described. The argon gas is introduced into the melting furnace 10a from the introduction port 22a for operation of the furnace under reduced pressure. In the chamber 20 in an argon atmosphere under reduced pressure, the sagger 12 having a silicon raw material charged therein is heated by the heating means 14 provided on side parts of the sagger 12, and the silicon raw material is melted under heating into a silicon melt 26. Then, the support means 16 having the sagger 12 placed thereon is lowered by rotating to lower the sagger 12 from a heated region. Thus, the silicon melt is cooled from a lower part of the sagger, solidified, and subjected to crystal growth, to thereby produce a polycrystalline silicon ingot. There is also known a method of melting and solidifying a silicon raw material under reduced pressure in an inert gas atmosphere containing hydrogen or in a hydrogen atmosphere (Patent Document 1).

Polycrystalline silicon for a solar cell has a crystal grain boundary, has unbonded active bonds (atomic defects), and contains impurities aggregated at the grain boundary compared with those of single crystal silicon to trap electrons in silicon during electron transfer and degrade life time characteristics of a silicon ingot. Further, a crystal grain itself has crystal defects including atomic defects and causes degradation of life time characteristics.

As described above, a method of producing polycrystalline silicon from a silicon ingot having a composition and a structure accelerating grain growth has been studied. However, acceleration of grain growth requires a long solidification time, and causes problems of increasing generation amounts of oxygen and carbon from a silicon dioxide sintered sagger to be used for a melting container in an argon atmosphere under reduced pressure and a carbon sagger, and carbon from a heater, dissolving oxygen and carbon in a silicon ingot, and increasing a concentration of oxygen, carbon, and other impurities to be melted in the silicon ingot. The increase of oxygen, carbon, and the impurities causes degradation of life time characteristics.

Meanwhile, grain growth is inhibited in the presence of atomic or lattice defects in crystal grains or in the presence of impurities at a crystal grain boundary. Grain growth for obtaining a target crystal grain size involves disadvantages in that a solidification rate must be low and ingot production requires a long period of time.

In a liquid phase solidification method, anisotropic growth is significant in grain growth with a low solidification rate for formation of crystals with few impurity defects or lattice defects, and non-uniform grains are formed. The formation of non-uniform grains involves formation of fine grains and causes mechanical damages in thickness reduction of a solar wafer.

A semiconductor wafer technique generally involves hydrogen treatment under low temperature heating for passivation of a dangling bond (active bond) to a single crystal silicon wafer. However, the hydrogen treatment is effective only for a surface layer of several tens µm, and a passivation effect cannot be obtained inside silicon. A solar cell wafer utilizes a total wafer thickness of several hundreds µm, and thus the hydrogen treatment is not in practical use for a method of producing a solar cell wafer because of problems including the passivation effect and increase in production cost such as a heat treatment cost. For a solar cell amorphous silicon wafer, hydrogen treatment employing plasma or the like is in practical use for crystallization acceleration and passivation of a dangling bond.
Patent Document 1: JP 58-99115 A

### Disclosure of the Invention

### Problems to be solved by the Invention

As described above, a conventional method involves the following phenomena. (1) For accelerating grain growth of a polycrystalline silicon melt, a long solidification time is required, and an electric power cost for production increases. (2) Melting for a long period of time increases concentrations of oxygen, carbon, and other impurities in an ingot and causes degradation of life time characteristics. (3) A liquid phase solidification method through argon/reduced pressure melting is liable to cause atomic and lattice defects during crystal formation and is more liable to form fine crystals. Such phenomena cause problems of degrading mechanical strength with thickness reduction and degrading life time characteristics.

An object of the present invention is to provide a method of polycrystalline silicon ingot having improved life time characteristics compared with those of a conventional product capable of producing a polycrystalline silicon ingot having a structure with few crystal defects and few fine crystal grains at low cost; and forming a high-purity silicon ingot compared with that produced by a conventional method by suppressing formation of impurities such as oxygen from a melting sagger and carbon from a furnace member, preventing melting and mixing of light-element impurities in a silicon melt, and removing the impurities in the melt through crystallization.

### Means for solving the Problems

For solving problems described above, a process for producing a polycrystalline silicon ingot of the present invention includes: melting a silicon raw material in a 100% hydrogen atmosphere under ordinary pressure or elevated pressure to prepare a silicon melt and simultaneously dissolving hydrogen in the silicon melt; solidifying the silicon melt containing hydrogen dissolved therein; maintaining the solid at a high temperature of about a solidification temperature for crystal growth to obtain a polycrystalline silicon ingot. The method of the present invention allows production of a polycrystalline silicon ingot having reduced fine crystals and reduced crystal defects.

In the method of the present invention, hydrogen dissolved in the silicon melt reacts with, gasifies, and removes light-element impurities such as oxygen and silicon monoxide in the silicon melt. Further, metal impurities including transition elements such as iron are removed through crystallization, and purification of the polycrystalline silicon ingot to be obtained is accelerated. A concentration of hydrogen dissolved in the silicon melt is high, and dissolution of other impurities in the silicon melt is reduced. Those effects improve life time characteristics of the polycrystalline silicon ingot to be obtained.

According to the method of the present invention, alignment of silicon atoms is accelerated through hydrogen dissolution in the silicon melt to form silicon crystals with little atomic defects. Further, hydrogen is bonded to atomic defects in a lattice to correct the atomic defects and improve life time characteristics. Generation of silicon monoxide through a reaction of a sagger formed of a silicon dioxide material to be used in melting of the silicon raw material and the silicon melt is suppressed through the hydrogen dissolution to reduce an oxygen concentration in the polycrystalline silicon ingot. Further, diffusion of impurities to be generated from a melting member, a releasing material, a heater, and the like to be used in melting of the silicon raw material into the silicon melt can be prevented.

### Effects of the Invention

According to the method of the present invention, a silicon raw material is melted in a 100% hydrogen atmosphere under ordinary pressure or elevated pressure to dissolve hydrogen in a silicon melt, and formation of atomic and lattice defects of a polycrystalline silicon ingot can be suppressed during solidification and solid phase growth. The dissolved hydrogen is subjected to reactive gasification with oxygen, accelerates crystallization of impurities in the silicon melt, and provides an effect of highly purifying the polycrystalline silicon ingot.

The method of the present invention accelerates lattice alignment at a grain boundary during grain growth after solidification and provides an effect of accelerating a crystal growth rate, leading to saving of electric power for melting.

The method of the present invention provides a passivation effect of hydrogen atoms to a dangling bond through solidification and solid phase growth of silicon in a state where hydrogen is dissolved in the silicon melt, and improves life time characteristics of the polycrystalline silicon ingot. Note that hydrogen passivation refers to an action of hydrogen atoms bonding to free bonds of silicon atomic defects, to thereby prevent electron annihilation during electron transfer in silicon.

### Brief Description of Drawings

Fig. 1 is a schematic diagram showing an example of a melting furnace to be used in the present invention.
Fig. 2 is a schematic diagram showing an example of a conventional melting furnace.
Fig. 3 is a graph showing fluctuation of upper temperature and lower temperature of a sagger with time in Example 1.
Fig. 4 is a graph showing fluctuation of upper temperature and lower temperature of a sagger in Comparative Example 1.
Fig. 5 is a graph showing a temperature program of upper temperature and lower temperature of a sagger employed in Example 2 and Comparative Example 2.
Fig. 6 is a photograph showing a crystal formation state of an ingot in Example 1.
Fig. 7 is a microphotograph showing an etch pit formation state in the ingot in Example 1.
Fig. 8 is a photograph showing a crystal formation state of an ingot in Comparative Example 1.
Fig. 9 is a microphotograph showing an etch pit formation state of the ingot in Comparative Example 1.
Fig. 10 is a photograph showing a crystal formation state (direction perpendicular to solidification axis) of an ingot in Example 2.
Fig. 11 is a photograph showing a crystal formation state (solidification axis direction) of the ingot in Example 2.
Fig. 12 is a microphotograph showing an etch pit formation state of the ingot in Example 2.
Fig. 13 is a photograph showing a crystal formation state (direction perpendicular to solidification axis) of an ingot in Comparative Example 2.
Fig. 14 is a photograph showing a crystal formation state (solidification axis direction) of the ingot in Comparative Example 2.
Fig. 15 is a microphotograph showing an etch pit formation state of the ingot in Comparative Example 2.
Fig. 16 is a graph showing Fe concentration distribution characteristics (section along solidification axis) of the ingot in Example 2.
Fig. 17 is a graph showing Fe concentration distribution characteristics (section perpendicular to solidification axis) of the ingot in Example 2.
Fig. 18 is a graph showing Fe concentration distribution characteristics (section along solidification axis) of the ingot in Comparative Example 2.
Fig. 19 is a graph showing Fe concentration distribution characteristics (section perpendicular to solidification axis) of the ingot in Comparative Example 2.
Fig. 20 is a graph showing life time characteristics (section along solidification axis) of the ingot in Example 2.
Fig. 21 is a graph showing life time characteristics (section perpendicular to solidification axis) of the ingot in Example 2.
Fig. 22 is a graph showing life time characteristics (section along solidification axis) of the ingot in Comparative Example 2.
Fig. 23 is a graph showing life time characteristics (section perpendicular to solidification axis) of the ingot in Comparative Example 2.

### Description of Reference Numerals

10a, 10b: melting furnace, 12: sagger, 14: heating means, 14a: upper side heating means, 14b: lower side heating means, 14c: upper heating means, 16:
support means, 18: heat insulation material, 20: chamber, 22a, 22b: gas introduction port, 24: discharge port, 26: silicon melt, 28 : inner cylinder tube, 30: furnace hearth

### Best Mode for carrying out the Invention

Hereinafter, embodiments of the present invention will be described based on attached drawings. However, the drawings are mere examples, and it is obvious that various changes may be made without departing from the scope of the invention.

The present invention refers to a process for producing a polycrystalline silicon ingot having reduced fine crystals of silicon including: removing through a reaction light-element impurities such as oxygen and nitrogen in a silicon melt during melting and solidification of a high-purity silicon raw material in a 100% hydrogen atmosphere under ordinary pressure or elevated pressure; reducing crystal defects through crystallization of other metal impurities; and conducting crystal growth. Through those effects, life time characteristics of the polycrystalline silicon ingot can be improved.

In the present invention, hydrogen is bonded to atomic defects in a lattice to be developed in the polycrystalline silicon ingot to correct the atomic defects, to thereby improve life time characteristics. Further, diffusion of impurities from silicon nitride used for a melting member or a releasing material to be used in melting of the silicon raw material in a hydrogen atmosphere into the polycrystalline silicon ingot can be prevented.

Fig. 1 is a schematic diagram showing an example of a melting furnace to be preferably used in the method of the present invention. In the method of the present invention, a melting furnace to be used generally employs a tungsten heater or molybdenum silicide not reacting with hydrogen in high temperatures. A furnace inner wall, a furnace hearth plate, or the like may employ silicon nitride, carbon nitride, or the like in addition to tungsten. A melting furnace shown in Fig. 1 is preferably used.

In Fig. 1, reference symbol 10b represents a melting furnace. The melting furnace 10b includes: a sagger 12; heating means 14 for heating the sagger 12; support means 16 for placing the sagger 12; a heat insulation material 18; and a chamber 20. The heat insulation material 18 is provided to cover an entire surface of an inner wall of the chamber 20. A hydrogen gas is introduced from a gas introduction port 22b and discharged from a discharge port 24. The heating means 14 as structural members of a furnace such as the heat insulation material 18 and a heating element or the like of the heating means 14 has a structure in which upper heating means 14c, upper side heating means 14a, and lower side heating means 14b are provided separately in an upper part, an upper side part, and a lower side part of the sagger 12, respectively, by splitting a heater circuit. The upper heating means 14c, the upper side heating means 14a, and the lower side heating means 14b separately conduct temperature control, and this structure has a function of providing a temperature gradient in a vertical direction of the sagger 12.

An operation of this structure will be described. The hydrogen gas is introduced into the melting furnace 10b from the introduction port 22b for operation of the furnace in a 100% hydrogen atmosphere under ordinary pressure or elevated pressure. In the chamber 20 in a hydrogen atmosphere under ordinary pressure or elevated pressure, the sagger 12 having a silicon raw material charged therein is heated by the upper heating means 14c provided above the sagger 12 and the upper side heating means 14a provided in an upper side part the sagger 12, and the silicon raw material is melted under heating into a silicon melt 26. Then, a furnace hearth 30 having the sagger 12 placed thereon is lowered and is positioned halfway between the upper side heating means 14a and the lower side heating means 14b for providing a vertical temperature gradient in the sagger 12, and the support means 16 is rotated. The upper heating means 14c, the upper side heating means 14a, and the lower side heating means 14b are controlled, to thereby cool and solidify the silicon melt from a lower part of the sagger 12 to a crystal growth temperature. Then, the heating means 14c, 14a, and 14b are maintained at a certain temperature for sufficient crystal growth, and the support means 16 is lowered, to thereby produce a polycrystalline silicon ingot.

### Examples

Hereinafter, the present invention will be described more specifically with reference to examples. However, the examples are mere examples and are not to be interpreted limitedly.

### (Example 1)

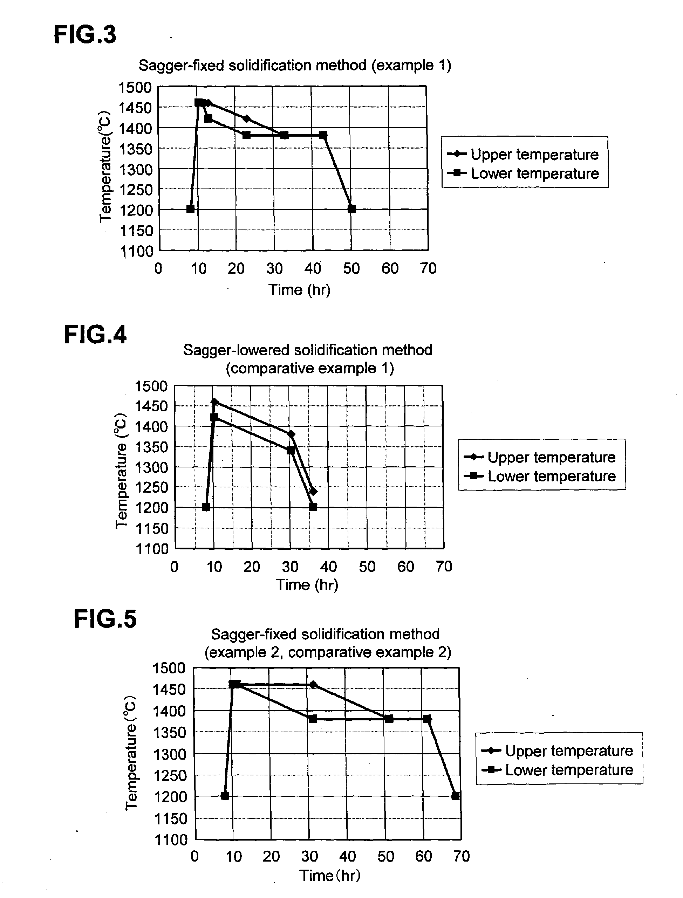

A releasing material (high-purity silicon nitride powder) was applied and dried on an inner wall of a silica-sintered sagger (inner dimensions of 175 mm x 350 mm), and a high-purity silicon raw material was charged into the sagger. The sagger was placed in a melting furnace having the same structure as that shown in Fig. 1 for melting. In Example 1, a polycrystalline silicon ingot was produced by: melting silicon in the melting furnace at 1,460°C and under slightly elevated pressure (500 Pa) with a hydrogen gas; reducing a temperature of a lower part of the sagger; sequentially cooling the entire sagger to 1,380°C at 25°C/hr while a vertical temperature gradient was provided in the sagger; solidifying a silicon melt from a lower part of the sagger; and maintaining the sagger at 1,380°C for 10 hr. An upper temperature (upper edge part) and a lower temperature (base part) of the sagger at this time were measured with a thermocouple, and Fig. 3 shows measured values of the temperatures.

### (Comparative Example 1)

An ingot was produced by a conventional sagger-lowered solidification method in an argon atmosphere. A melting furnace having the same structure as that shown in Fig. 1 was used, and the furnace atmosphere was changed to argon. Silicon was melted at 1,460°C, and then the sagger was lowered at 7 mm/hr. Upper and lower temperatures of the sagger at this time were measured in the same manner as in Example 1, and Fig. 4 shows the measured values of the temperatures. A cooling rate of the ingot was 4°C/hr.

### (Example 2)

An ingot was produced in a hydrogen gas atmosphere in the same manner as in Example 1 by using the same temperature program shown in Fig. 5 at 4°C/hr as that of argon atmosphere melting of Comparative Example 1.

### (Comparative Example 2)

An ingot was produced by using the temperature program shown in Fig. 5 in the same manner as in Example 2 and using an argon gas instead of the hydrogen gas.

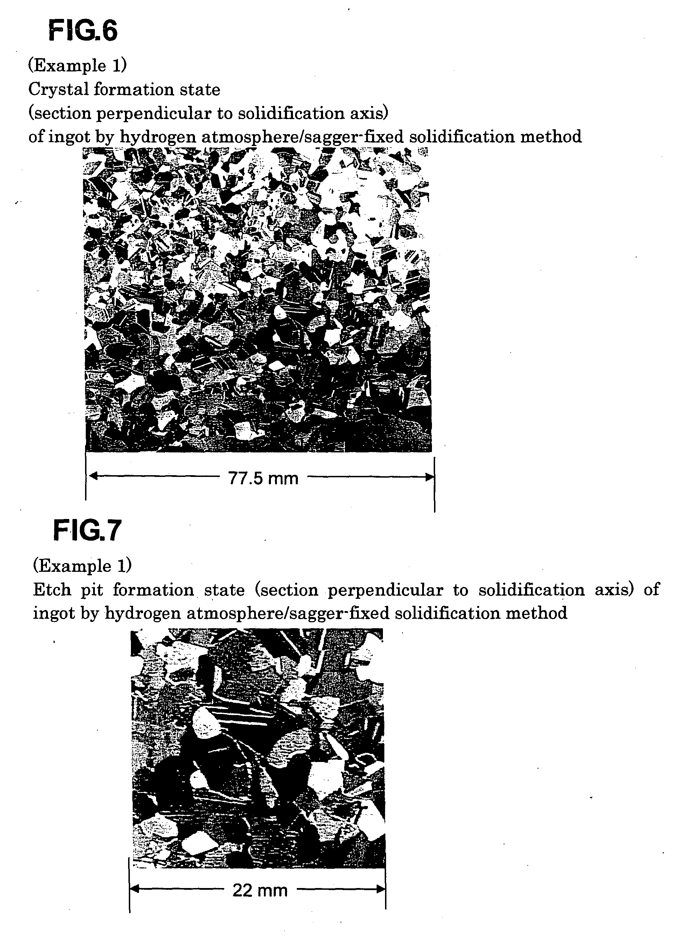

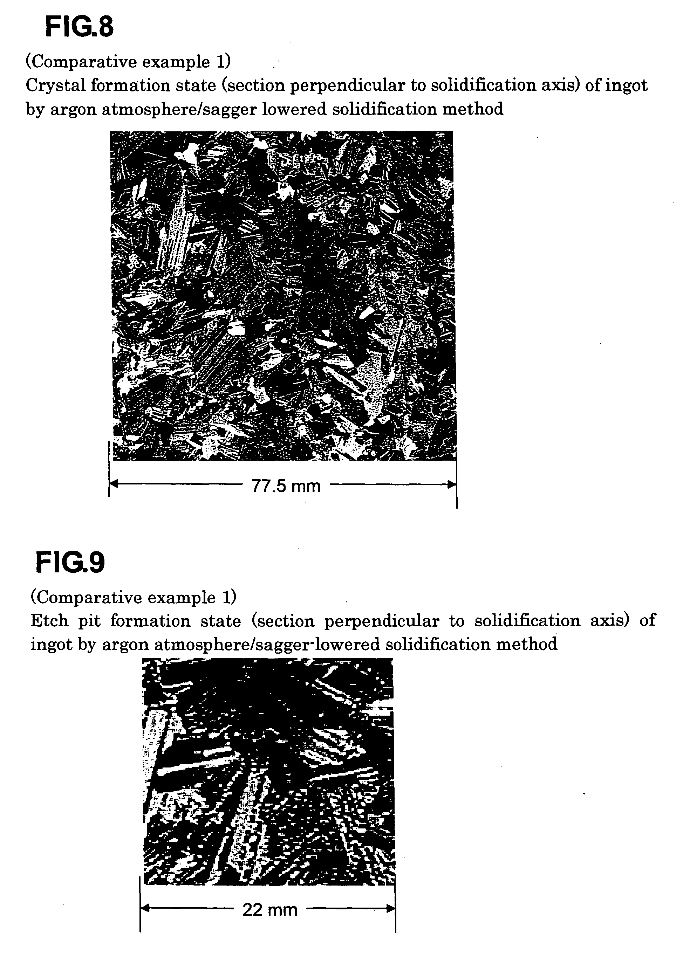

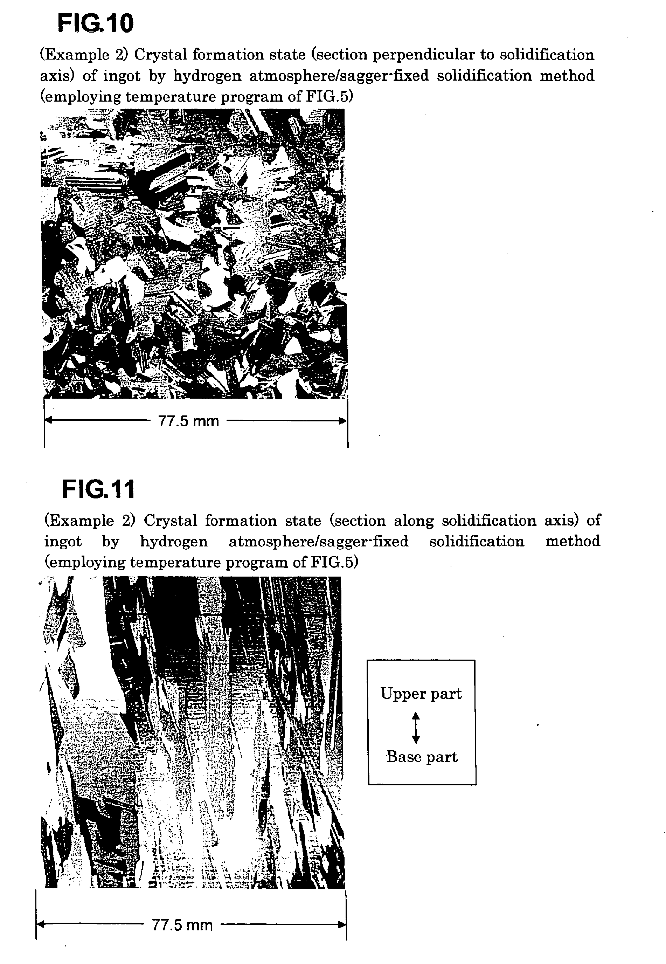

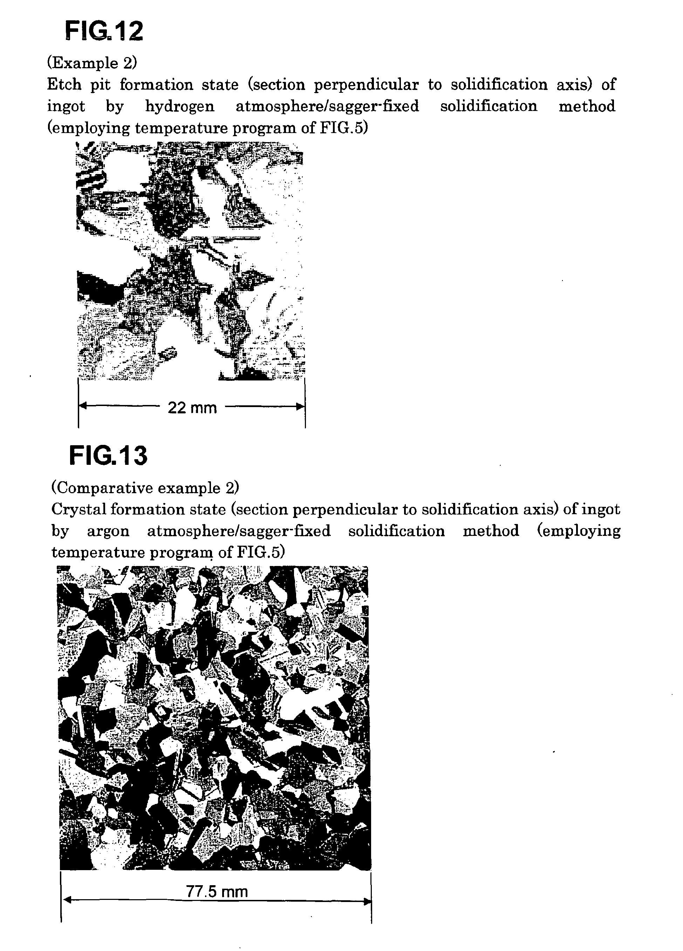

Figs. 6 to 15 each show a crystal formation state after cutting the polycrystalline silicon ingot obtained in each of Examples 1 and 2 and Comparative Examples 1 and 2 along a section perpendicular to a crystal growth axis and conducting alkali anisotropic etching treatment (Figs. 6 and 7: Example 1, Figs. 8 and 9: Comparative Example 1, Figs. 10 to 12: Example 2, Figs. 13 to 15: Comparative Example 2). Figs. 6, 8, 10, 11, 13, and 14 are each a photograph showing a crystal formation state, and Figs. 7, 9, 12, and 15 are each a microphotograph showing an etch pit formation state. The ingot of Comparative Example 1 was produced by lowering the sagger in an argon atmosphere as in the conventional method and cooling and solidifying at 4°C/hr. As shown in Fig. 8, crystal shapes varied significantly and included distorted shapes. Fig. 6 shows a crystal formation state of the ingot produced by rapidly solidifying at a cooling rate of 25°C/hr in a hydrogen atmosphere as Example 1. Crystal grains each had a relatively fine structure with a round grain boundary, and each had a structure with little anisotropic growth compared with crystals formed in an argon atmosphere shown in Fig. 8 (Comparative Example 1). Further, Fig. 9 (Comparative Example 1) and Fig. 7 (Example 1) each show etch pits indicating significant crystal defects. The argon-melt ingot of Fig. 9 (Comparative Example 1) had many etch pits observed, but the hydrogen-melt ingot of Fig. 7 (Example 1) had significantly reduced etch pits. The results revealed that the hydrogen-melting method allowed formation of an ingot having reduced crystal defects compared with that obtained by the conventional argon-melting method. Further, the results revealed that the ingot had a round crystal shape, and an occupancy ratio of a fine grain along a section perpendicular to a crystal axis was about 10% or less.

Example 2 and Comparative Example 2 each involved production by using a conventional cooling rate of 4°C/hr and by using a temperature program including maintaining the temperature for 10 hr after solidification as shown in Fig. 5. Figs. 10 to 12 (Example 2) and Figs. 13 to 15 (Comparative Example 2) each show a crystal formation state of the ingot solidified in a hydrogen atmosphere or an argon atmosphere. The ingots produced in the hydrogen atmosphere and the argon atmosphere had substantially similar characteristics of crystal size and crystal anisotropy by maintaining the temperature after solidification.

Table 1 shows evaluation results of characteristics of each of the ingots produced in Examples 1 and 2 and Comparative Examples 1 and 2. Life time characteristics of the obtained polycrystalline silicon ingots were 3.13 µs for Example 1 and 0.48 µs for Comparative Example 1, indicating that the life time characteristics were improved by the method of the present invention. The polycrystalline silicon ingots obtained in Example 1 and Comparative Example 1 were each subjected to anisotropic etching treatment and observed. As a result, the polycrystalline silicon ingot of Example 1 had reduced fine crystals and improved uniformity with small variation in grain size.

**[Table 1] Comparison table of ingots obtained in Examples 1 and 2 and Comparative Examples 1 and 2**

| | Melting atmosphere | Resistance | Life time characteristics | Oxygen concentration | Carbon concentration | Iron concentration |
|---|---|---|---|---|---|---|
| Example 1 | Hydrogen gas | 0.8Ωcm | 3.13µs | 0.38 x 10¹⁸ atoms/cc | 0.86 x 10¹⁶ atoms/cc | 47x10¹⁰ atoms/cc |
| Comparative example 1 | Argon gas | 0.9Ωcm | 0.48µs | 0.79 x 10¹⁸ atoms/cc | 0.8 x 10¹⁶ atoms/cc | 425 x 10¹⁰ atoms/cc |
| Example 2 | Hydrogen gas | 0.9Ωcm | 6.87µs | 0.34 x 10¹⁸ atoms/cc | 0.6 x 10¹⁶ atoms/cc | 12 x 10¹⁰ atoms/cc |
| Comparative example 2 | Argon gas | 0.9Ωcm | 1.18µs | 0.72 x 10¹⁸ atoms/cc | 0.89 x 10¹⁶ atoms/cc | 210 x 10¹⁰ atoms/cc |

Comparative Example 1 employed the method of lowering the sagger according to the existing production method, and the ingot had rather degraded life time characteristics of 0.48 µs compared with those of an existing product. The reason for the degraded life time characteristics is an effect of impurities diffused from a releasing material used for an inner surface of the sagger due to a small ingot shape. The Fe concentration was 425 x 10¹⁰ atoms/cc, which was a high value. The ingot of Example 1 was an ingot produced in a hydrogen atmosphere at the same cooling rate as that of Comparative Example 1. The ingot had reduced impurities such as Fe and improved life time characteristics.

The ingots of Example 2 and Comparative Example 2 each were ingots each produced in a hydrogen or argon atmosphere by using the temperature program of Fig. 5 including maintaining the temperature at a solidification temperature. The hydrogen atmosphere ingot (Example 2) had life time characteristics of 6.87 µs in a center part with little Fe diffusion. Meanwhile, the argon atmosphere ingot (Comparative Example 2) had life time characteristics of 1.2 µs, which was a low value.

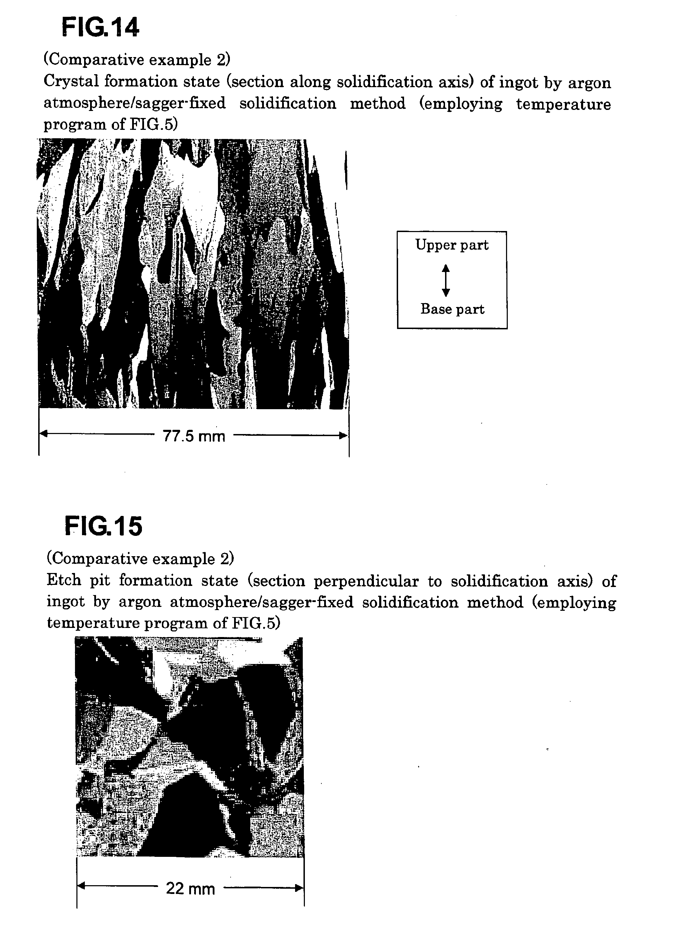

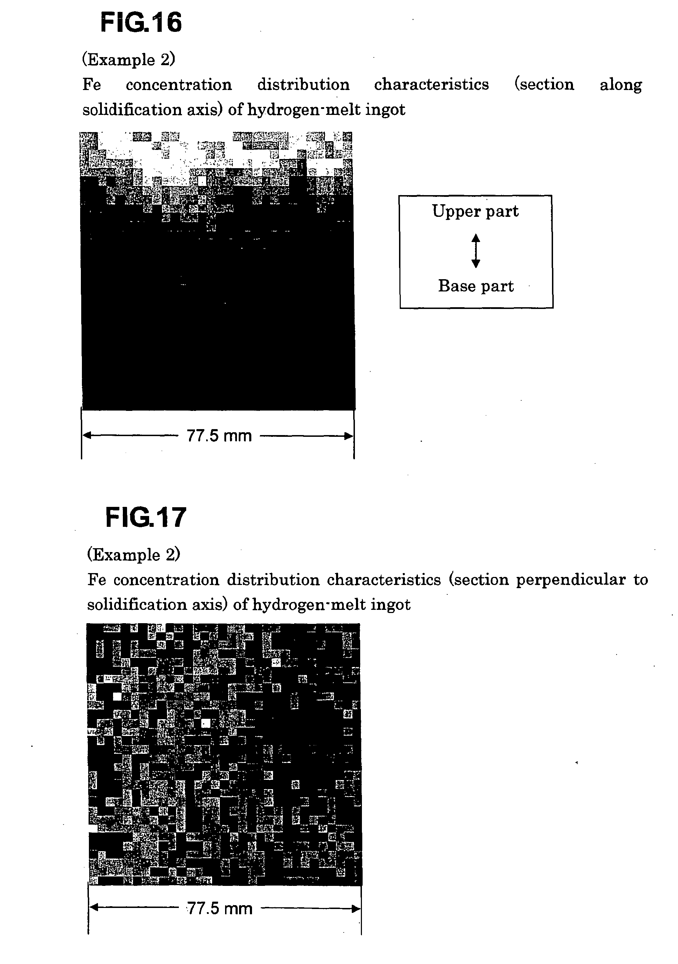

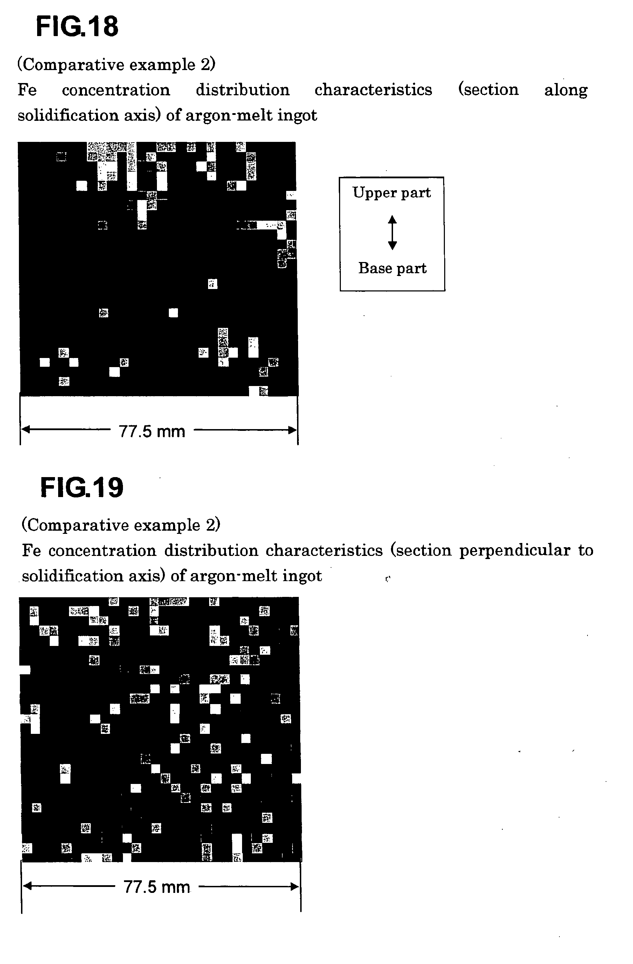

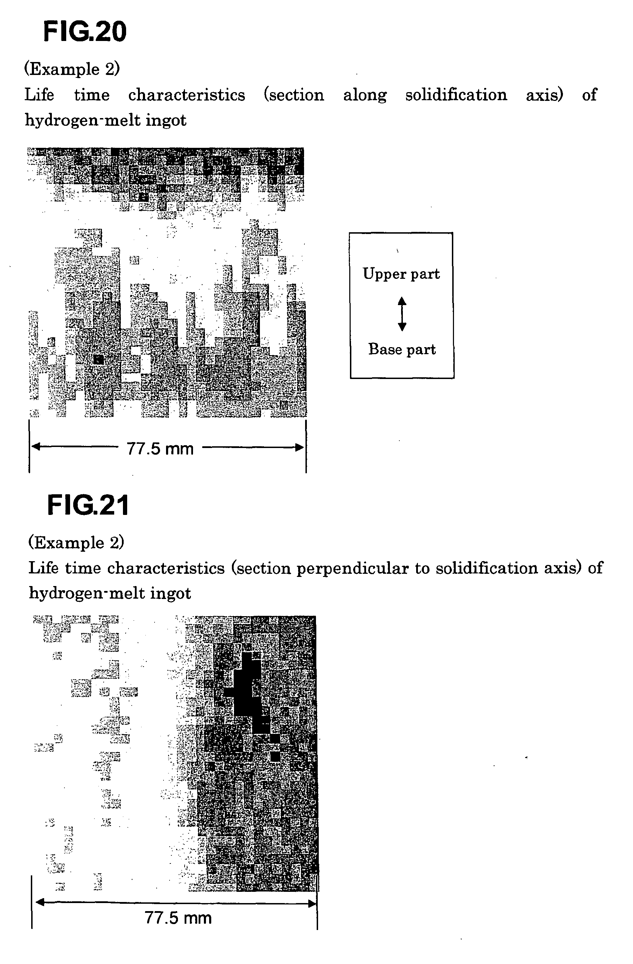

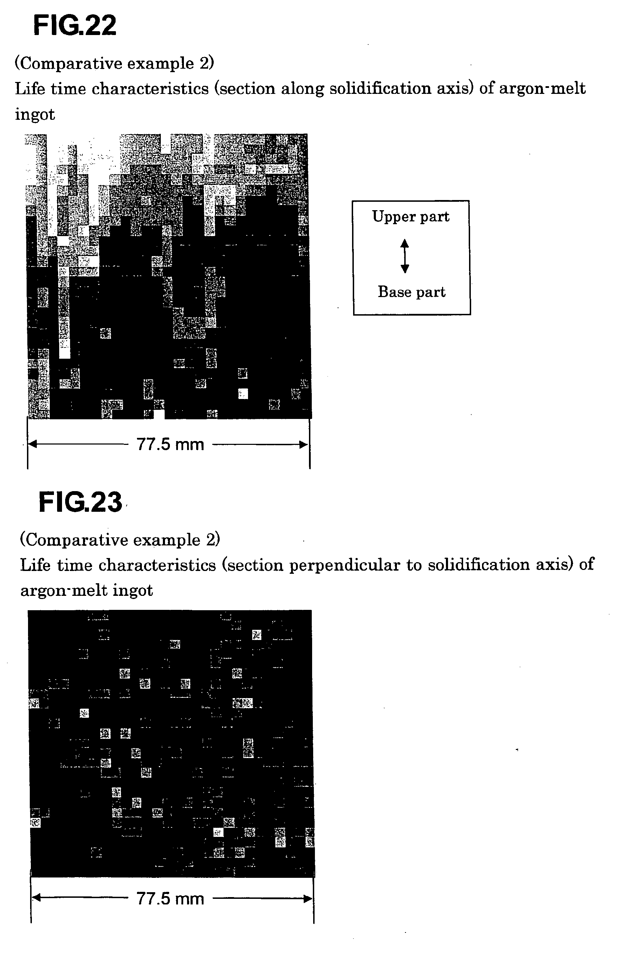

As reasons for the results, Figs. 16 and 17 (Example 2) and Figs. 18 and 19 (Comparative Example 2) show Fe distribution concentration characteristics, and Figs. 20 and 21 (Example 2) and Figs. 22 and 23 (Comparative Example 2) show life time characteristics. The life time characteristics were measured with a life time measuring device manufactured by SEMILAB (Semiconductor Physics Laboratory, Inc). Distribution on a section along a solidification axis of the hydrogen-melt ingot indicated a correlation among the Fe concentration of Fig. 16 (Example 2), the life time characteristics of Fig. 20 (Example 2), and the crystal formation state of Fig. 12 (Example 2). Meanwhile, the argon-melt ingot had no correlation among the Fe concentration of Fig. 18 (Comparative Example 2), the life time characteristics of Fig. 22 (Comparative Example 2), and the crystal formation state of Fig. 15 (Comparative Example 2). As shown in Fig. 17 (Example 2), the hydrogen-melt ingot had a small absolute value of the Fe concentration and had a concentration difference in Fe diffusion from the sagger on the section perpendicular to the solidification axis, but the argon-melt ingot shown in Fig. 19 (Comparative Example 2) had high concentration and had no significant concentration gradient. This phenomenon provides a purification action involving: reducing diffusion amounts of impurities into silicon because hydrogen is dissolved in a silicon melt; and crystallizing the impurities in silicon crystal formation.

The results of a hydrogen gas analysis of the hydrogen-melt ingot (Examples 1 and 2) of the present invention confirmed hydrogen, but quantitative determination of radical hydrogen is not possible by the current analysis method. However, the silicon ingot produced by the current argon-melt method contains no hydrogen. A semiconductor wafer may be subjected to hydrogen treatment, but it is not possible costwise that an inexpensive solar wafer be subjected to hydrogen treatment because the treatment cost is high.

The method of the present invention allows melting of silicon in a hydrogen atmosphere under ordinary pressure, reduction of fine crystals by a solidification method employing a solid phase growth method, reduction of impurities through hydrogen dissolution, and purification of silicon through crystallization of the impurities.

In Example 1, rapid solidification was conducted at a cooling rate of 25°C/hr, and in Example 2, gradual solidification as in the conventional method was conducted at a cooling rate of 4°C/hr. The results revealed that the ingot of Example 2 had improved life time characteristics and reduced impurities such as Fe compared with those of the ingot of Example 1. The results revealed that a favorable ingot can be obtained through gradual solidification than rapid solidification. However, a gradual cooling rate reduces a crystal formation rate of the ingot and reduces efficiency. Thus, in an actual operation, an appropriate cooling rate is set in consideration of quality and economical effects.

## Claims

1. A process for producing a solar polycrystalline silicon ingot comprising: melting a silicon raw material in a 100% hydrogen atmosphere under ordinary pressure or elevated pressure to prepare a silicon melt and simultaneously dissolving hydrogen in the silicon melt; solidifying the silicon melt containing hydrogen dissolved therein; and maintaining the solid at a high temperature of about a solidification temperature for growth of silicon crystal grains in a solid phase to obtain a polycrystalline silicon ingot.

2. The process for producing a solar polycrystalline silicon ingot according to claim 1, wherein hydrogen is bonded to atomic defects in a lattice to be developed in the polycrystalline silicon ingot to correct the atomic defects and to improve life time characteristics.

3. The process for producing a solar polycrystalline silicon ingot according to claim 1 or 2, wherein hydrogen dissolved in the silicon melt prevents diffusion and mixing of impurities into the silicon melt and removes the impurities in the silicon melt through reactive gasification or crystallization to accelerate purification of the polycrystalline silicon ingot.

4. The process for producing a solar polycrystalline silicon ingot according to any one of claims 1 to 3, wherein generation of silicon monoxide through a reaction of a sagger formed of a silicon dioxide material to be used in melting of the silicon raw material and the silicon raw material is suppressed in the hydrogen atmosphere, and an oxygen concentration in the polycrystalline silicon ingot is reduced.

5. The process for producing a solar polycrystalline silicon ingot according to any one of claims 1 to 4, wherein diffusion of impurities to be generated from a melting member to be used in melting of the silicon raw material into the polycrystalline silicon ingot is prevented.
